(19) Europäisches Patentamt
European Patent Office
Office européen des brevets

(11) EP 2 400 541 A1

(12) **EUROPEAN PATENT APPLICATION**
published in accordance with Art. 153(4) EPC

(43) Date of publication:
**28.12.2011 Bulletin 2011/52**

(21) Application number: **10743719.6**

(22) Date of filing: **15.02.2010**

(51) Int Cl.:
***H01L 23/02*** *(2006.01)* ***H01L 23/10*** *(2006.01)*
***H01L 27/14*** *(2006.01)*

(86) International application number:
**PCT/JP2010/052194**

(87) International publication number:
**WO 2010/095593 (26.08.2010 Gazette 2010/34)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **23.02.2009 JP 2009039860**

(71) Applicant: **Sumitomo Bakelite Company Limited**
**Shinagawa-ku**
**Tokyo 140-0002 (JP)**

(72) Inventors:
- **DEJIMA Hirohisa**
  **Tokyo 140-0002 (JP)**
- **KAWATA Masakazu**
  **Tokyo 140-0002 (JP)**
- **YONEYAMA Masahiro**
  **Tokyo 140-0002 (JP)**
- **TAKAHASHI Toyosei**
  **Tokyo 140-0002 (JP)**
- **SHIRAISHI Fumihiro**
  **Tokyo 140-0002 (JP)**
- **SATO Toshihiro**
  **Tokyo 140-0002 (JP)**

(74) Representative: **Solf, Alexander**
**Patentanwälte**
**Dr. Solf und Zapf**
**Candidplatz 15**
**D-81543 München (DE)**

# (54) SEMICONDUCTOR WAFER ASSEMBLY, METHOD FOR PRODUCING SEMICONDUCTOR WAFER ASSEMBLY, AND SEMICONDUCTOR DEVICE

(57) A semiconductor wafer bonding product according to the present invention includes: a semiconductor wafer; a transparent substrate provided at a side of a functional surface of the semiconductor wafer; a spacer provided between the semiconductor water and the transparent substrate; and a bonded portion continously proved along a periphery of the semiconductor wafer, the transparent subsrate being bonded to the semiconductor wafer through the bonded portion. It is preferred that a minimum width of the bonded portion is 50 $\mu$m or more.

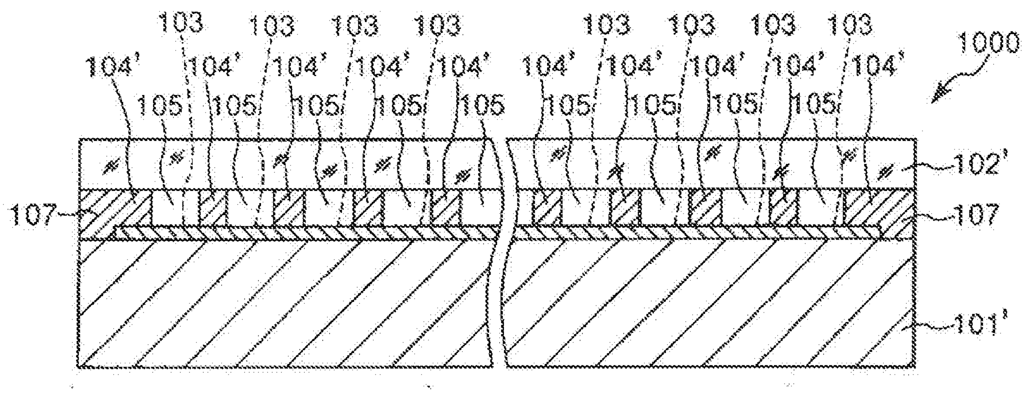


FIG. 2



Printed by Jouve, 75001 PARIS (FR)

**Description**

## TECHNICAL FIELD

The present invention relates to a semiconductor wafer bonding product, a method of manufacturing a semiconductor wafer bonding product and a semiconductor device.

## RELATED ART

Semiconductor devices represented by a CMOS sensor, a CCD sensor and the like are known. In general, such a semiconductor device includes a semiconductor substrate provided with a light receiving portion, a spacer provided on the semiconductor substrate and formed so as to surround the light receiving portion, and a transparent substrate bonded to the semiconductor substrate via the spacer.

Such a semiconductor device is generally manufactured using a manufacturing method including: a step of attaching a bonding film having an electron beam curable property to a semiconductor wafer on which a plurality of light receiving portions are provided; a step of selectively irradiating the bonding film with an electron beam via a mask to expose the bonding film; a step of developing the exposed bonding film to form the spacer; a step of bonding a transparent substrate to the thus formed spacer to obtain a semiconductor product (hereinbelow, it will be referred to as "semiconductor wafer bonding product"); and a step of dicing the semiconductor product to obtain semiconductor devices (see, for example, Patent Document 1).

Further, generally, before the semiconductor wafer bonding product is diced, a rear surface of the semiconductor wafer is subjected to a processing such as formation of a circuit (wiring) or formation of solder bumps (this step is referred to as a rear surface processing step).

However, in the semiconductor wafer bonding product manufactured using the conventional method, since a width of the spacer is small, there is a problem in that a part of the spacer existing in the vicinity of a peripheral edge of the semiconductor wafer bonding product is removed or peeled off by a cleaning fluid, an etching solution or the like which is used in the rear surface processing step, so that the cleaning fluid, the etching solution or the like penetrates into an inside of the semiconductor wafer bonding product from that part.

There is also another problem in that a semiconductor device obtained from a portion of the semiconductor wafer bonding product into which such a liquid has penetrated becomes a defective product, as a result of which the number of semiconductor devices to be obtained from one semiconductor wafer bonding product is reduced, to thereby cause lowering of productivity of the semiconductor devices.

The Patent Document 1 is Japanese Patent Application Laid-open No. 2004-312666.

## SUMMARY OF THE INVENTION

It is an object of the present invention to provide a semiconductor wafer bonding product that can prevent a cleaning fluid, an etching solution or the like from penetrating into an inside thereof in processing a rear surface of a semiconductor wafer, and thus has excellent productivity of semiconductor devices, to provide a manufacturing method capable of easily manufacturing such a semiconductor wafer bonding product, and to provide a semiconductor device having superior reliability.

In order to achieve such an object, the present invention includes the following features (1) to (11).

(1) A semiconductor wafer bonding product, comprising:

- a semiconductor wafer;
- a transparent substrate provided at a side of a functional surface of the semiconductor wafer;
- a spacer provided between the semiconductor wafer and the transparent substrate; and
- a bonded portion continuously provided along a periphery of the semiconductor wafer, the transparent substrate being bonded to the semiconductor wafer through the bonded portion.

(2) The semiconductor wafer bonding product according to the above feature (1), wherein a minimum width of the bonded portion is 50 μm or more.

(3) The semiconductor wafer bonding product according to the above feature (1), wherein a ratio of die shear strength of the bonded portion after being dipped into an etching solution with respect to that of the bonded portion before being dipped into the etching solution is 40% or more.

(4) The semiconductor wafer bonding product according to the above feature (1), wherein the bonded portion is integrally formed with the spacer.

(5) A method of manufacturing the semiconductor wafer bonding product defined by claim 1, comprising:

a step of forming a photosensitive bonding layer having a shape corresponding to that of the semiconductor wafer and having a bonding property onto the functional surface of the semiconductor wafer;
a step of selectively exposing a region of the photosensitive bonding layer to be formed into the spacer and the bonded portion via a mask;
a step of developing the photosensitive bonding layer to form the spacer and the bonded portion on the semiconductor wafer; and
a step of bonding the transparent substrate to surfaces of the spacer and the bonded portion opposite to the semiconductor wafer.

(6) A method of manufacturing the semiconductor wafer bonding product defined by claim 1, comprising:

a step of forming a photosensitive bonding layer having a shape corresponding to that of the semiconductor wafer and having a bonding property onto the transparent substrate;
a step of selectively exposing a region of the photosensitive bonding layer to be formed into the spacer and the bonded portion via a mask;
a step of developing the photosensitive bonding layer to form the spacer and the bonded portion on the transparent substrate; and
a step of bonding the semiconductor wafer to surfaces of the spacer and the bonded portion opposite to the transparent substrate.

(7) The method according to the above feature (5) or (6), wherein the photosensitive bonding layer is formed of a material containing an alkali soluble resin, a thermosetting resin and a photo polymerization initiator.

(8) The method according to the above feature (7), wherein the alkali soluble resin is a (meth)acry-modified phenol resin.

(9) The method according to the above feature (7), wherein the thermosetting resin is an epoxy resin.

(10) The method according to the above feature (7), wherein the material 1 further contains a photo polymerizable resin.

(11) A semiconductor device obtained by dicing the semiconductor wafer bonding product defined by claim 1 along a portion corresponding to the spacer to obtain a plurality of chips of semiconductor devices.

## BRIEF DESCRIPTION OF THE DRAWINGS

FIG. 1 is a sectional view snowing one example of a semiconductor device according to the present invention.

FIG. 2 is a longitudinal sectional view showing one example of a semiconductor wafer bonding product according to the present invention.

FIG. 3 is a top view showing one example of the semiconductor wafer bonding product according to the present invention.

FIG. 4 is a process chart showing one example of a method of manufacturing the semiconductor device (semiconductor wafer bonding product) according to the present invention.

FIG. 5 is a process chart showing one example of the method of manufacturing the semiconductor device (semiconductor wafer bonding product) according to the present invention.

## BEST MODE FOR CARRYING OUT THE INVENTION

Hereinafter, description will be made on the present invention in detail.

<Semiconductor device (image sensor)>

First, description will be made on a semiconductor device manufactured using a semiconductor wafer bonding product according to the present invention, prior to description of a semiconductor wafer bonding product according to the present invention.

FIG. 1 is a sectional view showing one example of the semiconductor device according to the present invention. In this regard, in the following description, the upper side in FIG. 1 will, 1. be referred to as "upper" and the lower side thereof will be referred to as "lower".

As shown in FIG. 1, a semiconductor device (light receiving device) 100 includes a base substrate 101, a transparent substrate 102 provided so as to face the base substrate 101, a light, receiving portion 103 formed on the base substrate 101, a spacer 104 formed on an edge of the light receiving portion 103, and solder bumps 106 each formed on a lower surface of the base substrate 101.

The base substrate 101 is a semiconductor substrate. On the semiconductor substrate, provided is a circuit (individual circuit formed on a semiconductor wafer described below) which is not shown in the drawing.

On almost a whole surface of the base substrate 101, the light receiving portion 103 is provided. For examples, the light receiving portion 103 has a structure in which a light receiving element and a microlens array are laminated (stacked) in this order from a side of the base substrate 101.

The transparent substrate 102 is provided so as to face the base substrate 101 and has a planar size substantially equal to a planar size of the base substrate 101. For example, the transparent substrate 102 is formed from an acryl resin substrate, a polyethylene terephthalate resin (PET) substrate, a glass substrate or the like.

The spacer 104 directly bonds the microlens array of the light receiving portion 103 to the transparent substrate 102 along an edge thereof, to thereby bond the base substrate 101 to the transparent substrate 102. And, this spacer 104 forms (defines) an air-gap portion 105 between the light receiving portion 103 (microlens array) and the transparent substrate 102.

Since this spacer 104 is provided on the edge of the light receiving portion 103 so as to surround a central area of tne light receiving portion 103, an area of the light receiving portion 103 surrounded by the spacer 104 can substantially function as a light receiving portion.

In this regard, it is to be noted that examples of the light receiving element of the light receiving portion 103 include CCD (Charge Coupled Device), CMOS (Complementary Metal Oxide Semiconductor) and the like. Such a light receiving element changes light received by the light receiving portion 103 to electrical signals.

The solder bumps 106 have conductivity and are electrically connected to a circuit provided on the lower surface of the base substrate 101. This makes it possible for the electrical signals changed from the light in the light receiving portion 103 to be transmitted to the solder bumps 106.

<Semiconductor wafer bonding product>

Next, description will be made on a semiconductor wafer bonding product.

FIG. 2 is a longitudinal sectional view showing one example of the semiconductor wafer bonding product according to the present invention, and FIG. 3 is a top view showing one example of the semiconductor wafer bonding product according to the present invention. In this regard, in the following description, the lower direction in FIG. 2 will be referred to as "lower side" or "down direction" and the upper direction thereof will be referred to as "upper side" or "up direction".

As shown in FIG. 2, a semiconductor wafer bonding product 1000 includes a semiconductor wafer 101', a spacer 104', a bonded portion 107 and a transparent substrate 102'.

The semiconductor wafer 101' becomes the base substrate 101 of the semiconductor device 100 described above through a dicing step described below.

Further, on a functional surface of the semiconductor wafer 101', a plurality of individual circuits (not shown in the drawings) are provided.

Furthermore, on the functional surface of the semiconductor wafer 101', the light receiving portion 103 is formed corresponding to each of the individual circuits.

As shown in FIG. 3, the spacer 104' has a grid-like shape and is provided so as to surround each of the individual circuits (light receiving portions 103) formed on the semiconductor wafer 101'. Further, the spacer 104' forms (defines) a plurality of air-gap portions 105 between the semiconductor wafer 101' and the transparent substrate 102'. Namely, regions each surrounding by the spacer 104' become the air-gap portions 105.

Further, a lower surface of the spacer 104' is bonded to the semiconductor wafer 101', whereas an upper surface of the spacer 104' is bonded to the transparent substrate 102'.

This spacer 104' is a member which becomes the spacer 104 of the semiconductor device 100 as described above through the dicing step as described below.

An average thickness of the spacer 104' (spacer 104) is preferably in the range of 5 to 500 $\mu$m, and more preferably in the range of 10 to 400 $\mu$m.

As shown in FIGs. 2 and 3, the bonded portion 107 is provided on a periphery of the semiconductor wafer 101'. Further, the bonded portion 107 is provided so as to join to the spacer 104'. Namely, the bonded portion 107 is integrally formed with the spacer 104'.

The bonded portion 107 bonds the transparent substrate 102' described below to the semiconductor wafer 101' along a periphery thereof.

Meanwhile, in a conventional semiconductor wafer bonding product, since a width of a spacer is small, there is a problem in that a part of the spacer existing in the vicinity of a peripheral edge of the semiconductor wafer bonding product is removed of peeled off by a cleaning fluid, an etching solution or the like which is used in processing a rear surface, so that the clearing fluid, the etching solution or the like penetrates into an inside of the semiconductor wafer bonding product from that part.

There is also a problem in that a semiconductor device obtained from a portion of the semiconductor wafer bonding product into which such a liquid has penetrated becomes a defective product, as a result of which the number of semiconductor devices to be obtained from one semiconductor wafer bonding product is reduced, to thereby cause lowering of productivity of the semiconductor devices.

On the other hand, according to the present invention, as described above, the bonded portion bonds the transparent substrate to the semiconductor wafer along a periphery thereof. Therefore, it is possible to prevent a cleaning fluid, an etching solution or the like which is used in processing a rear surface from penetrating into an inside of the semiconductor wafer bonding product from a peripheral edge thereof. As a result, it is possible to reduce the number of defective products among semiconductor devices to be obtained from one semiconductor wafer bonding product, to thereby improve productivity of the semiconductor devices.

A shortest distance between the air-gap portion 105 and the peripheral edge of the semiconductor wafer 101', that is, a minimum width of the bonded portion 107 is preferably 20 $\mu$m or more, and more preferably in the range of 50 $\mu$m to 1 cm. This makes it possible to more reliably bond the transparent substrate 102' to the semiconductor wafer 101'. Therefore, it is possible to more reliably prevent a liquid such as the cleaning fluid or the etching solution from penetrating into the inside of the semiconductor wafer bonding product 1000 from the peripheral edge thereof in processing the rear surface, As a result, it is possible to further reduce the number of defective products among the semiconductor devices to be obtained from one semiconductor wafer bonding product, to thereby especially improve the productivity of the semiconductor devices.

Specifically, an average thickness (height) of the bonded portion 107 is preferably in the range of 5 to 500 $\mu$m, and more preferably in the range of 10 to 400 $\mu$m.

The transparent substrate 102' is bonded to the semiconductor substrate 101' via the above spacer 104' and bonded portion 107.

This transparent substrate 102' is a member which becomes the transparent substrate 102 of the semiconductor device 100 as described above through the dicing step as described below.

Such a semiconductor wafer bonding product 1000 is diced as described below so that a plurality of the semiconductor devices 100 can be obtained.

In this regard, in the above description, the bonded portion 107 is integrally formed with the spacer 104', but is not limited thereto, may be formed separately from the spacer 104' using a dispenser or the like.

<Method of Manufacturing semiconductor device (semiconductor wafer bonding products)>

Next, description will be made on a preferred embodiment of the method of manufacturing a semiconductor device (semiconductor wafer bonding product) according to the present invention.

FIGs. 4 and 5 are process charts each showing the preferred embodiment of the method of manufacturing the semiconductor device (semiconductor wafer bonding product) according to the present invention,

[1] First, a photosensitive bonding film 1 is prepared.
As shown in FIG, 4(a), the photosensitive bonding film 1 includes a support base 11 and a photosensitive bonding layer 12 provided on the support base 11.

The support base 11 is a base (member) having a sheet-like shape and has a function for supporting the photosensitive bonding layer 12.

This support base 11 is formed, of a material having optical transparency. By forming the support base 11 using such a material having optical transparency, exposure of the photosensitive bonding layer 12 can be carried out while attaching the support base 11 to the photosensitive bonding layer 12 in manufacturing the semiconductor device as described below.

Visible light transmission through the support base 11 is preferably in the range of 30 to 100%, and more preferably in the range of 50 to 100%. This makes it possible to more reliably expose the photosensitive bonding layer 12 during an exposing step described below. Further, this also makes it possible to more reliably carry out positioning between alignment marks of a mask and alignment marks of the semiconductor wafer 101' (transparent substrate 102' as described below.

For example, an average thickness of the support base 11 is preferably in the range of 15 to 50 $\mu$m, and more preferably in the range of 25 to 50 $\mu$m. If tne average thickness of the support base 11 is less than the above limit value, there is a case that it is difficult to obtain strength required as a support base. On the other hand, if the average thickness of the support base 11 exceeds the above upper limit value, there is a case that handing ability of the photosensitive bonding film is lowered.

For example, examples of a material constituting such a support base 11 include polyethylene terephthalate (PET), polypropylene (pp), polyethylene (PE) and the like. Among them, it is preferable to use the polyethylene terephthalate (PET) from the viewpoint of having optical transparency and rupture strength in excellent balance.

The photosensitive bonding layer 12 has a bonding property with respect to a surface of the semiconductor wafer and is a layer to be bonded to the semiconductor wafer. This photosensitive bonding layer 12 is a layer to be used for forming the spacer 104' and the bonded portion 107 included in the above semiconductor wafer bonding product 1000. A resin composition constituting the photosensitive bonding layer 12 will be described below in detail.

A ratio of die shear strength of the bonded portion 107 after being dipped into an etching solution with respect tc that of the bonded portion 107 before being dipped into the etching solution is preferably 40% or more, and more preferably 60% or more. By setting the ratio of die shear strength of the bonded portion 107 after being dipped into an etching solution with respect to that of the bonded portion 107 before being dipped into the etching solution to a value exceeding the above range, it is possible to more reliably prevent the etching solution from penetrating into the inside of the semiconductor wafer bonding product 1000 from the peripheral edge thereof in processing the rear surface of the semiconductor wafer.

In this regard, it is to be noted that the ratio of die shear strength of the bonded portion 107 after being dipped into an etching solution with respect to that of the bonded portion 107 before being dipped into the etching solution is calculated using the following method.

A resin composition for forming the bonded portion 107 is attached to a borosilicate glass substrate by techniques such as laminate. Next, a bonding layer having a size of 2 mm square is formed, for example, by techniques such as exposure (e.g., 700 J/$cm^2$) and development (e.g., 3% TMAH developer, 25°C/0.3 MPa/90, sec), a glass substrate having a size of 2 mm square is placed on the bonding layer, and then the glass substrates are bonded together by thermocompression bonding (120°C $\times$ 0.8 MPa $\times$ 5 s). A sample for measuring die shear strength is obtained by subjecting the bonded glass substrates to a heat history of 150°C $\times$ 90 minutes. In the same manner as described above, 20 samples are obtained in total.

10 obtained samples are untreated, and other 10 obtained samples are treated using an etching solution "FE-830" produced by EBARA DENSAN LTD.) of 30°C for 5 minutes and washed using pure water for 5 minutes. On each

of the samples, the die shear strength thereof is calculated using a die shear strength measuring machine.

Further, a ratio of the die shear strength of the sample after being dipped into the etching solution with respect to that of the sample before being dipped into the etching solution is calculated based on the following expression.

Ratio of die shear strength (%) = (Die shear strength of sample after being dipped into etching solution) / (Die shear strength of untreated sample) × 100

Visible light transmission through the photosensitive bonding layer 12 is preferably in the range of 30 to 100%, and more preferably in the range of 50 to 100%. This makes it possible to more reliably expose the photosensitive bonding layer 12 along a thickness direction thereof during the exposure step described below. Further, this also makes it possible to more reliably carry out the positioning between the alignment marks of the mask and the alignment marks of the semiconductor wafer 101' (transparent substrate 102') as described below.

Here, the visible light transmission through the support base 11 and photosensitive bonding layer 12 can be measured using the following method.

The visible light transmission is measured using a light having a measuring wavelength of 600 nm by a transmission measuring device ("UV-160A" produced by Shimadzu Corporation) In this regard, in the case of the support base, utilized is a support base to be actually used as a measuring sample, whereas in the case of the photosensitive bonding layer, utilized is a photosensitive bonding layer having a thickness of 50 μm as the measuring sample.

On the other hand, prepared is a semiconductor wafer 101' having a plurality of light receiving portions 103 and maicrolens arrays (not shown in the drawings) formed on a functional surface thereof (see FIG. 4(b)).

[2] Next, as shown in FIG. 4(c), the photosensitive bonding layer 12 (bonding surface) of the photosensitive bonding film 1 is attached to the functional surface of the semiconductor wafer 101'. In this way, the photosensitive bonding layer 12 is attached to the semiconductor wafer 101' at a side of the light receiving portions 103 thereof in a state that the support base 11 is provided on the photosensitive bonding layer 12 at an opposite side of the semiconductor wafer 101'. Namely, the photosensitive bonding layer 12 is formed on the functional surface of the semiconductor wafer 101' (this step is referred to as a photosensitive bonding layer forming step).

In this regard, for example, the attachment of the photosensitive bonding layer 12 to a surface (upper surface) of the semiconductor wafer 101' at the side of the light receiving portions 103 is carried out in the following manner.

(1) First, the photosensitive bonding film 1 is aligned with the semiconductor wafer 101', and then a lower surface of the photosensitive bonding film 1 makes contact with the upper surface of the semiconductor wafer 101' in one end side thereof.

(2) Next, in this state, the photosensitive bonding film 1 and the semiconductor wafer 101' are set to a bonding machine so as to be tightly held between a pair of rollers at a portion in which the lower surface of the photosensitive bonding film 1 makes contact with the upper surface of the semiconductor wafer 101'. In this way, the photosensitive bonding film 1 and the semiconductor wafer 101' are pressurized.

(3) Next, the pair of rollers are moved from the one end side toward the other side. At this time, the photosensitive bonding layer 12 is sequentially bonded to the light receiving portions 103 at a position tightly held between the rollers. As a result, the photosensitive bonding layer 12 is bonded to the semiconductor wafer 101'.

When being tightly held by the pair of rollers in the bonding, by adjusting a pressure therebetween, it is possible to set thicknesses of the spacer 104' and the bonded portion 107 to desired values.

When the photosensitive bonding film 1 and the semiconductor wafer 101' are tightly held between the pair of rollers, the pressure therebetween is not limited to a specific value, but is preferably in the range of about 0.1 to 10 $kgf/cm^2$, and more preferably in the range of about 0.2 to 5 $kgf/cm^2$. This makes it possible to reliably bond the photosensitive bonding layer 12 to the semiconductor wafer 101',

A moving speed of each of the rollers is not limited to a specific value, but is preferably in the range of about 0.1 to 1.0 m/min, and more preferably in the range of about 0.3 to 0.6 m/min,

Further, each of the rollers is provided with a heating means such as a header, and therefore the photosensitive bonding film 1 and the semiconductor wafer 101' are heated at the portion tightly held between the pair of rollers. A temperature when being heated is preferably in the range of about 0 to 120°C, and more preferably in the range of about 40 to 100°C.

(3) Next, the photosensitive bonding layer 12 is irradiated with a light (ultraviolet ray) to expose it (this step is referred to as an exposing step).

At this time, as shown in FIG. 4(d), used is a mask 20 having a light passing portion 201 at a position corresponding to

a portion to be formed into the spacer 104 and the bonded portion 107. The light passing portion 201 is a portion through which the light is passed, and the photosensitive bonding layer 12 is irradiated with the light passed through the light passing portion 201.

therefore, a region of the photosensitive bonding layer 12, which is irradiated with the passed light, is selectively exposed. In this way, in the photosensitive bonding layer 12, the region irradiated with the light is photo-cured.

Further, as shown in FIG. 4(d), the exposure of the photosensitive bonding layer 12 is preferably carried out in a state that the support base 11 is attached to the photosensitive bonding layer 12, that is, using an exposure light passed through the support base 11.

This makes it possible for the support base 11 to function as a protective layer of the photosensitive bonding layer 12, to thereby prevent adhesion of foreign substances such as dust to the surface of the photosensitive bonding layer 12 effectively. Further, in the case where the foreign substances adhere to the support base 11, they can be easily removed. Furthermore, even when the mask 20 is placed, it is possible to prevent for the mask 20 to adhere to the photosensitive bonding layer 12, while making the distance between the mask 20 and the photosensitive bonding layer 12 smaller. As a result, it is possible to prevent the image formed from the exposure light with which the photosensitive bonding layer 12 is irradiated from becoming dim.

In this case, the border between the exposed region and the non-exposed region can become sharp (clear). As a result, it is possible to form the spacer at sufficient dimensional accuracy, to thereby obtain each air-gap portion 105 surrounded by the spacer 104' so as to have a close designed shape. This makes it possible to obtain a semiconductor device having superior reliability.

Further, in the present embodiment, as shown in FIG. 4(d), on the semiconductor wafer 101' and in the vicinity of a peripheral edge thereof, alignment marks 1011 are provided.

Furthermore, in the same way, as shown in FIG. 4(d), on the mask 20, alignment marks 202 for positioning are provided.

In the present exposing step, positioning of the mask 20 with respect to the semiconductor wafer 101' is carried out by aligning tne alignment marks 1011 of the above semiconductor wafer 101' with the alignment marks 202 of the mask 20. This makes it possible to form the spacer 104' at high location accuracy, to thereby further improve reliability of the formed semiconductor device 100.

In this regard, it is to be noted that after the exposure, the photosensitive bonding layer 12 may be subjected to a baking (heating) treatment at a temperature of about 40 to 80°C (this step is referred to as a post exposure baking step (PEB step)). By being subjected to such a baking treatment, it is possible to further improve adhesion between a region photo-cured during the exposing step (spacer 104') and the semiconductor wafer 101', to thereby effectively prevent undesired peeling-off of the photo-cured region during a developing step described below.

The temperature of the baking treatment only have to fall within the above range, but is preferably in the range of 50 to 10°C. This makes it possible to further effectively prevent the undesired peeling-off of the photo-cured region during the developing step described below.

[4] Next, as shown in FIG. 4(e), the support base 11 is removed (this step is referred to as a support base removing step).

[5] Next, as shown in FIG. 4(f), the photosensitive bonding layer 12 is developed using an alkali aqueous solution. At this time, a non-cured region of the photosensitive bonding layer 12 is removed so that the photo-cured region is remained as a spacer 104' having a grid-like shape and a boded portion 107 (this step is referred to as a developing step). In other words, formed are regions 105' to be converted into the plurality of air-gap portions 105 between the semiconductor wafer 101' and the transparent substrate 102'.

[6] Next, as shown in FIG. 5(g), the transparent substrate 102' is bonded to upper surfaces of the formed spacer 104' and the bonded portion 107 (this step is referred to as a bonding step). In this way, it is possible to obtain a semiconductor wafer bonding product 1000 (semiconductor wafer bonding product of the present invention) in which the semiconductor wafer 101', the spacer 104' and the transparent substrate 102' are laminated in this order.

The bonding of the transparent substrate 102' to the spacer 104' and the bonded portion 107 can be carried out, for example, by attaching the transparent substrate 102' to the upper surfaces of the formed spacer 104' and the bonded portion 107, and then being subjected to thermocompression bonding.

The thermocompression bonding is preferably carried out within a temperature range of 80 to 180°C. This makes it possible to form the spacer 104 so as to have a favorable shape and to more reliably bond the transparent substrate 102' to the semiconductor wafer 101' along the periphery thereof. As a result, it is possible to more reliably prevent the liquid such as the cleaning fluid or the etching solution from penetrating into the inside of the semiconductor wafer bonding product 1000 from the peripheral edge thereof in processing the rear surface as described above.

[7] Next, as shown in FIG. 5(h), ground is a lower surface (rear surface) 111 of the semiconductor wafer 101' opposite to the surface to which the transparent substrate 102' is bonded (this step is referred to as a back grinding step).

This lower surface 111 can be ground by, for example, a grinding plate provided in a grinding machine (grinder).

By grinding such a lower surface 111, a thickness of the semiconductor wafer 101' is generally set to about

100 to 600 μm depending on an electronic device in which the semiconductor device 100 is used. In the case where the semiconductor device 100 is used in an electronic device having a smaller size, the thickness of the semiconductor wafer 101' is set to about 50 μm,

[8] Next, the lower surface (rear surface) 111 of the ground semiconductor wafer 101' is subjected to a processing (this step is referred to as a rear surface processing step).

Examples of such a processing include, for example, formation of a circuit (wiring) onto the lower surface 111, connection of the solder bumps 106 thereto as shown in FIG. 5(i), and the like. In this regard, although the formation of the circuit is generally carried out by spattering, plating and/or etching, since the transparent substrate 102' is bonded to the semiconductor wafer 101' along the periphery thereof, it is possible to reliably prevent the cleaning fluid, the etching solution or the like from penetrating into the inside of the semiconductor wafer bonding product 1000.

[9] Next, the semiconductor wafer bonding product 1000 is diced so as to correspond to each individual circuit formed on the semiconductor wafer 101', that is, each air-gap portion 105 inside the spacer 104, to thereby obtain the plurality of semiconductor devices 100 (this step is referred to as a dicing step). In other words, by dicing the semiconductor wafer bonding product 1000 along a portion corresponding to the spacer 104' and then being separated, the plurality of semiconductor devices 100 are obtained.

For example, the dicing of the semiconductor wafer bonding product 1000 is carried out by, as shown in FIG. 5(j), forming grooves 21 from a side of the semiconductor wafer 101' using a dicing saw so as to correspond to a position where the spacer 104' is formed, and then also forming grooves from a side of the transparent substrate 102' using the dicing saw so as to correspond to the grooves 21.
Through the above steps, the semiconductor device 100 can be manufactured.

In this way, by dicing the semiconductor wafer bonding product 1000 to thereby obtain the plurality of semiconductor devices 100 at the same time, it is possible to mass-produce the semiconductor devices 100, and thus to improve productive efficiency thereof. Especially, since the semiconductor wafer bonding product 1000 has a high liquid-tight structure described above, it is possible to prevent or suppress occurrence of defective products, to thereby manufacture the semiconductor devices 100 at a high yield ratio.

In this regard, for example, by mounting the semiconductor device 100 on a support substrate provided with a circuit (patterned wiring) via the solder bumps 106, the circuit formed on the support substrate is electrically connected to the circuit formed on the lower surface of the base substrate 101 via the solder bumps 106.

Further, the semiconductor device 100 mounted on the support substrate is widely used in electronics such as a cellular telephone, a digital camera, a video camera and a miniature camera.

In this regard, in the description of the present embodiment, the PEB step is carried out by exposing the photosensitive bonding layer 12 and then baking it, but be omitted depending on the kind of a resin composition constituting the photosensitive bonding layer 12.

Further, in the above description, the support base 11 has the light transmissive property, but may not have the light transmissive property. In this case, the above exposing step is carried out after the support base 11 is removed from the photosensitive bonding layer 12.

Furthermore, in the above description, the bonded portion 107 is integrally formed with the spacer 104', but may be formed using a dispenser or the like after the spacer 104' is formed.

Moreover, in the above description, the exposure is carried out after the photosensitive bonding Layer 12 is formed on the semiconductor wafer 101', but may be carried out after the photosensitive bonding layer 12 is formed on the transparent substrate 102'.

<Resin composition constituting photosensitive bonding layer 12>

Next, description will be made on a preferred embodiment of the resin composition constituting the photosensitive bonding layer 12.
The photosensitive bonding layer 12 is a layer having a photo curable property, an alkali developable property and a thermosetting property, and is formed of a material (resin composition) containing an alkali soluble resin, a thermosetting resin and a photo polymerization initiator.

Hereinbelow, description will be made on each component of the resin composition in detail.

(Alkali soluble resin)

The resin composition constituting the photosensitive bonding layer 12 contains the alkali soluble resin. This makes it possible to have the alkali developable property to the photosensitive bonding layer 12.

Examples of the alkali soluble resin include: a novolac resin such as a cresol-type novolac resin, a phenol-type novolac resin, a bisphenol A-type novolac resin, a bisphenol F-type novolac resin, a catechol-type novolac resin, a resorcinol-type novolac resin and a pyrogallol-type novolac resin; a phenol aralkyl resin; a hydroxystyrene resin; an

acryl-based resin such as a methacrylic acid resin and a methacrylic acid ester resin; a cyclic olefin-based resin containing hydroxyl groups, carboxyl groups and the like; a polyamide-based resin; and the like. These alkali soluble resins may be used singly or in combination of two or more of them.
In this regard, concrete examples of the polyamide-based resin include: a resin containing at least one of a polybenzoxazole structure and a polyimide structure, and hydroxyl groups, carboxyl groups, ether groups or ester groups in a main chain or branch chains thereof; a resin containing a polybenzoxazole precursor structure; a resin containing a polyimide precursor structure; a resin containing a polyamide acid ester structure; and the like.

Among these alkali soluble resins, it is preferable to use an alkali soluble resin containing both alkali soluble groups, which contribute to the alkali developing, and double bonds.

Examples of the alkali soluble groups include a hydroxyl group, a carboxyl group and the like. The alkali soluble groups can contribute to a thermal curing reaction in addition to the alkali developing. Further, since the alkali soluble resin contains the double bonds, it also can contribute to a photo curing reaction.

Examples of such a resin containing alkali soluble groups and double bonds include a curable resin which can be cured by both heat and light. Concrete examples of the curable resin include a thermosetting resin containing photo reaction groups such as an acryloyl group, a methacryloyl group and a vinyl group; a photo curable resin containing thermal reaction groups such as a phenolic hydroxyl group, an alcoholic hydroxyl group, a carboxyl group and an anhydride group; and the like.

In this regard, it is to be noted that the photo curable resin containing thermal reaction groups may further have thermal reaction groups such as an epoxy group, an amino group and a cyanate group. Concrete examples of the photo curable resin having such a chemical structure include a (meth)acryl-modified phenol resin, an acryl acid polymer containing (meth)acryloyl groups, an (epoxy)acrylate containing carboxyl groups, and the like. Further, the photo curable resin may be a thermoplastic resin such as an acryl resin containing carboxyl groups.

Among the above resins each containing alkali soluble groups and double bonds (curable resins which can be cured by both heat and light), it is preferable to use the (meth)acryl-modified phenol resin.
By using the (meth)acryl-modified phenol resin, since the resin contains the alkali soluble groups, when the resin which has not reacted is removed during a developing treatment, an alkali solution having less adverse effect on environment can be used as a developer instead of an organic solvent which is normally used. Further, since the resin contains the double bonds, these double bonds contribute to the curing reaction. As a result, it is possible to improve heat resistance of the resin composition.
Further, by using the (meth)acryl-modified phenol resin, it is possible to reliably reduce a degree of warp of the semiconductor wafer bonding product 1000. From the viewpoint of such a fact, it is also preferable to use the (meth)acryl-modified phenol resin.

Examples of the (meth)acryl-modified phenol resin include a (meth)acryloyl-modified bisphenol resin obtained by reacting hydroxyl groups contained in bisphenols with epoxy groups of compounds containing epoxy groups and (meth)acryloyl groups.

Concretely, examples of such a (meth)acryloyl-modified bisphenol resin include a resin represented by the following chemical formula 1.

[0109] [Chemical formula 1]

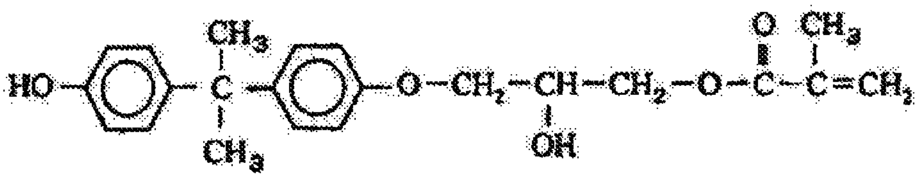

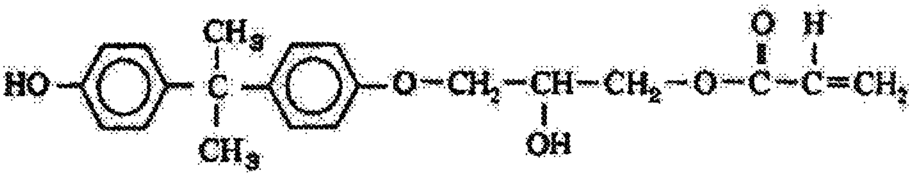

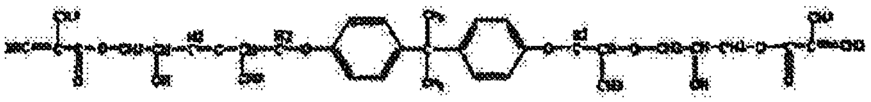

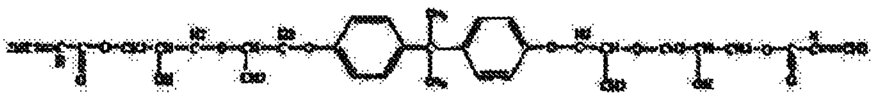

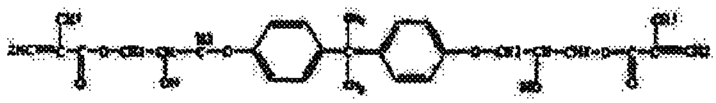

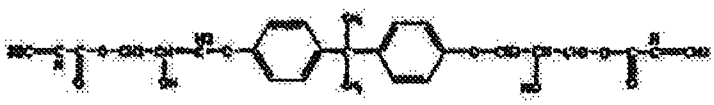

Further, as another (meth)acryloyl-modified bisphenol resin, exemplified is a compound introducing a dibasic acid into a molecular chain of a (meth)acryloyl-modified epoxy resin in which (meth) acryloyl groups are bonded to both ends of an epoxy resin, the compound obtained by bonding one of carboxyl groups of the dibasic acid to one hydroxyl group of the molecular chain of the (meth)acryloyl-modified epoxy resin via an ester bond. In this regard, it is to be noted that this compound has one or more repeating units of the epoxy resin and one or more dibasic acids introduced into the molecular chain.

Such a compound can be synthesized by reacting epoxy groups existing both ends of an epoxy resin obtained by polymerizing epichorohydrin and polyalcohol with (meth)acrylic acid to obtain a (meth)acryloyl-modified epoxy resin in which acryloyl groups are introduced into both the ends of the epoxy resin, and then reacting hydroxyl groups of a molecular chain of the (meth)acryloyl-modified epoxy resin with an anhydride of a dibasic acid to form an ester bond together with one of carboxyl groups of the dibasic acid.

Here, in the case of using the thermosetting resin containing photo reaction groups, a modified ratio (substitutional ratio) of the photo reaction groups is not limited to a specific value, but is preferably in the range of about 20 to 80%, and more preferably about 30 to 70% with respect to total reaction groups of the resin containing alkali soluble groups and double bonds. If the modified ratio of the photo reaction groups falls within the above range, it is possible to provide a resin composition having an excellent developing property.

On the other hand, in the case of using the photo curable resin containing thermal reaction groups, a modified ratio (substitutional ratio) of the thermal reaction groups is not limited to a specific value, but is preferably in the range of about 20 to 80%, and more preferably in the range of about 30 to 70% with respect to total reaction groups of the resin containing alkali soluble groups and double bonds. If the modified ratio of the thermal reaction groups falls within the above range, it is possible to provide a resin composition having an excellent developing property.

Further, in the case where the resin having alkali soluble groups and double bonds is used as the alkali soluble resin, a weight-average molecular weight of the resin is not limited to a specific value, but is preferably 30,000 or less, and more preferably in the range of about 5,000 to 15,000. If the weight-average molecular weight falls within the above range, it is possible to further improve a film forming property of the resin composition in forming the photosensitive bonding layer onto a film (support base).

Here, the weight-average molecular weight of the alkali soluble rein can be measured using, for example, a gel permeation chromatographic method (GPC). That is, according to such a method, the weight-average molecular weight can be calculated based on a calibration curve which has been, in advance, made using styrene standard substances. In this regard, it is to be noted that the measurement is carried out using tetrahydrofuran (THF) as a measurement solvent at a measurement temperature of 40°C.

Further, an amount of the alkali soluble resin contained in the resin composition is not limited to a specific value, but is preferably in the range of about 15 to 50 wt%, and more preferably in the range of about 20 to 40 wt% with respect to a total amount of the resin composition. In this regard, in the case where the resin composition contains a filler described below, the amount of the alkali soluble resin may be preferably in the range of about 10 to 80 wt%, and more preferably in the range of about 15 to 70 wt% with respect to resin components container in the resin composition (total components excluding the filler).

If the amount of the alkali soluble resin is less than the above lower limit value, there is a fear that an effect of improving compatibility with other components (e.g., a photo curable resin and thermosetting resin described below) contained in the resin composition is lowered. On the other hand, if the amount of the alkali soluble resin exceeds the upper limit value, there is a fear that the developing property of the resin composition or patterning resolution of the spacer formed by a photo lithography technique is lowered. In other words, by allowing the amount of the alkali soluble resin to fall within the above range, the resin composition can more reliably exhibit a property suitable for the thermocompression bonding after being patterned by the photo lithography technique.

(Thermosetting resin)

Further, the resin composition constituting the photosensitive bonding layer 12 also contains the thermosetting resin. This makes it possible for the photosensitive bonding layer 12 to exhibit a bonding property due to curing thereof, even after being exposed and developed. Namely, the transparent substrate 10 can be bonded to the photosensitive bonding layer 12 by the thermocompression bonding, after the photosensitive bonding layer 12 has been bonded to the semiconductor wafer, and exposed and developed.

In this regard, in the case where the curable resin which can be cured by heat is used as the above alkali soluble resin, a resin other than the curable resin is selected as the thermosetting resin.

Concretely, examples of the thermosetting resin include: a novolac-type phenol resin such as a phenol novolac resin, a cresol novolac resin and a bisphenol A novolac resin; a phenol resin such as a resol phenol resin; a bisphenol-type epoxy resin such as a bisphenol A epoxy resin and a bisphenol F epoxy resin; a novlolac-type epoxy resin such as a novolac epoxy resin and a cresol novolac epoxy resin; an epoxy resin such as a biphenyl-type epoxy resin, a stilbene-type epoxy resin, a triphenol methane-type epoxy resin, an alkyl-modified triphonol methane-type epoxy resin, a triazine chemical structure-containing epoxy resin and a dicyclopentadiene-modified phenol-type epoxy resin; an urea resin; a resin having triazine rings such as a melamine resin; an unsaturated polyester resin; a bismaleimide resin; a polyurethane resins a diallyl phthalate resin; a silicone resin; a resin having benzooxazine rings; a cyanate ester resin; an epoxy-modified-siloxane; and the like. These thermosetting resins may be used singly or in combination of two or more of them.

Among them, it is preferable Lo use the epoxy resin. This makes it possible to improve heat resistance of the resin composition and adhesion of the transparent substrate 1 thereto.

Further, in the case of using the epoxy resin, it is preferred that both an epoxy resin in a solid form at room temperature (in particular, bisphenol-type epoxy resin and an epoxy resin in a liquid form at room temperature (in particular silicone-modified epoxy resin in a liquid form at room temperature) are used together as the epoxy resin. This makes it possible to obtain a photosensitive bonding layer 12 having excellent flexibility and resolutions while maintaining heat resistance thereof.

An amount of the thermosetting resin contained in the resin composition is not limited to a specific value, but preferably in the range of about 10 to 40 wt%, and more preferably in the range of about 15 to 35 wt% with respect to the total amount of the resin composition. If the amount of the thermosetting resin is less than the above lower limit value, there is a case that an effect of improving the heat resistance of the photosensitive bonding layer 12 to be obtained is lowered. On the other hand, if the amount of the thermosetting resin exceeds the above upper limit value, there is a case that an effect of improving toughness of the photosensitive bonding layer 12 is lowered.

Further, in the case of using the above epoxy resin, it is preferred that the thermosetting resin further contains the phenol novolac resin in addition to the epoxy resin. Addition of the phenol novolac resin makes it possible to improve

the resolution of the photosensitive bonding layer 12. Furthermore, in the case where the resin composition contains both the epoxy resin and the phenol novolac resin as the thermosetting resin, it is also possibly to obtain an advantage that the thermosetting property of the epoxy resin can be further improved, to thereby make the strength of the spacer 104 higher.

(Photo polymerization initiator)

The resin composition constituting the photosensitive bonding layer 12 also contains the photo polymerization initiator. This makes it possible to effectively pattern the photosensitive bonding layer 12 through photo polymerization.
Examples of the photo polymerization initiator include benzophenone, acetophenone, benzoin, benzoin isobutyl ether, benzoin methyl benzoate, benzoin benzoic acid, benzoin methyl ether, benzyl phenyl sulfide, benzyl, dibenzyl, diacetyl, dibenzyl dimethyl ketal and the like,
**[0129]** An amount of the photo polymerization initiator contained in the resin composition is not limited to a specific value, but is preferably in the range of about 0.5 to 5 wt%, and more preferably in the range of about 0.8 to 3.0 wt% with respect to the total amount of the resin composition. If the amount of the photo polymerization initiator is less than the above lower limit value, there is a fear that an effect of starting the photo polymerization is lowered. On the other hard, if the amount of the photo polymerization initiator exceeds the above upper limit value, reactivity of the resin composition is extremely improved, and therefore there is a fear that storage stability or resolution thereof is lowered.

(Photo polymerizable resin)

It is preferred that the resin composition constituting the photosensitive bonding layer 12 also contains a photo polymerizable resin in addition to the above components. In this case, since the photo polymerizable resin is contained in the resin composition together with the above alkali soluble resin, it is possible to further improve a patterning property of the photosensitive bonding layer 12 to be obtained.
In this regard, in the case where the curable resin which can be cured by light is used as the above alkali soluble resin, a resin other than the curable resin is selected as the photo polymerizable resin.
Examples of the photo polymerizable resin include: but are not limited to, an unsaturated polyester; an acryl-based compound such as an acryl-based monomer and an acryl-based oligomer each containing one or more acryloyl groups or one or more methacryloyl groups in a chemical structure thereof; a vinyl-based compound such as styrene; and the like. These photo polymerizable resins may be used singly or in combination of two or more of them.
Among them, an ultraviolet curable resin containing the acryl-based compound as a major component thereof is preferable. This is because a curing rate of the acryl-based compound is fast when being exposed with light, and therefore it is possible to appropriately pattern the resin with a relative small exposure amount.
Examples of the acryl-based compound include a monomer of an acrylic acid ester or methacrylic acid ester, and the like. Concretely, examples of the monomer include: a difunctional (meth)acrylate such as ethylene glycol di (meth)acrylate, 1,6-hexanediol di(meth)acrylate, glycerin di(meth)acrylate and 1,10-decanediol di(meth)acrylate; a trifunctional (meth)acrylate such as trimethylol propane tri(meth)acrylate and pentaerythritol tri(meth)acrylate; a tetrafunctional (meth)acrylate such as pentaerythritol Letra(meth)acrylate and ditrimethylol propane tetra(meth)acrylate; a hexafunctional (meth)acrylate such as dipentaerythritol hexa(meth)acrylate; and the like.
Among these acryl-based compounds, it is preferable to use an acryl-based polyfunctional monomer. This makes it possible for the spacer 104 to be obtained from the photosensitive bonding layer 12 to exhibit excellent strength. As a result, a semiconductor device 100 provided with the spacer 104 can have a more superior shape keeping property.
In this regard, it is to be noted that, in the present specification, the acryl-based polyfunctional monomer means a monomer of a (meth)acrylic acid ester containing three or more acryloyl groups or (meth)acryloyl groups.
Further, among the acryl-based polyfunctional monomers, it is more preferable to use the trifunctional (meth) acrylate or the tetrafunctional (meth)acrylate. This makes it possible to exhibit the above effects more remarkably.
In this regard, in the case of using the acryl-based polyfunctional monomer, it is preferred that the photo polymerizable resin further contains an epoxy vinyl ester resin. In this case, since the acryl-based polyfunctional monomer is reacted with the epoxy vinyl ester resin by radical polymerization when exposing the photosensitive bonding layer 12, it is possible to more effectively improve the strength of the spacer 104 to be formed. On the other hand, it is possible to improve solubility of the non-exposed region of the photosensitive bonding layer 12 with the alkali developer when developing it, to thereby reduce residues after the development.
Examples of the epoxy vinyl ester resin include 2-hydroxyl-3-phenoxypropyl acrylate, EPOLIGHT 40E methacryl addition product, EPOLIGHT 70P acrylic acid addition product, EPOLIGHT 200P acrylic acid addition product, EPOLIGHT 80MF acrylic acid addition product, EPOLIGHT 3002 methacrylic acid addition product, EPOLIGHT 3002 acrylic acid addition product, EPOLIGHT 1600 acrylic acid addition product, bisphenol A diglycidyl ether methacrylic acid addition product, bisphenol A diglycidyl ether acrylic acid addition product, EPOLIGHT 200E acrylic acid addition product, EPOLIGHT 400E acrylic acid addition product, and the like.

In the case where the photo polymerizable resin contains the acryl-based polyfunctional monomer, an amount of the acryl-based polyfunctional monomer contained in the resin composition is not limited to a specific value, but is preferably in the range of about 1 to 50 wt% nd more preferably in the range of about 5 to 25 wt% with respect to the total amount of the resin composition. This makes it possible to more effectively improve the strength of the photosensitive bonding layer 12 after being exposed, that is, the spacer 104, and thus to more effectively improve the shape keeping property thereof when the transparent substrate 102 is bonded to the semiconductor wafer 101'.

Further, in the case where the photo polymerizable resin contains the epoxy vinyl ester resin in addition to the acryl-based polyfunctional monomer, an amount of the epoxy vinyl ester resin is not limited to a specific value, but is preferably in the range of about 3 to 30 wt%, and more preferably in the range of about 5 to 15 wt% with respect to the total amount of the resin composition. This makes it possible to more effectively reduce a residual ratio of residues attached to each surface of the semiconductor wafer and transparent substrate after the transparent substrate is bonded to the semiconductor wafer.

Further, it is preferred that the above photo polymerizable resin is in a liquid form at room temperature. This makes it possible to further improve curing reactivity of the photo polymerizable resin by light irradiation (e.g., by ultraviolet ray irradiation). Further, it is possible to easily mix the photo polymerizable resin with the other components (e.g. alkali soluble resin). Examples of the photo polymerizable resin in the liquid form at the room temperature include the above ultraviolet curable resin containing the acryl-based compound as the major component thereof, and the like,

In this regard, it is to be noted that a weight-average molecular weight of the photo polymerizable resin is not limited to a specific value, but is preferably 5,000 or less, and more preferably in the range of about 150 to 3,000. It the weight-average molecular weight falls within the above range, sensitivity of the photosensitive bonding layer 12 becomes specifically higher. Further, the photosensitive bonding layer 12 can also have superior resolution.

Here, the weight-average molecular weight of tne photo polymerizable resin can be measured using the gel permeation chromatographic method (GPC), and is calculated in the same manner as described above.

(Inorganic filler)

In this regard, it is to be noted that the resin composition constituting the photosensitive bonding layer 12 may also contain an inorganic filler. This makes it possible to further improve the strength of the spacer 104 to be formed from the photosensitive bonding layer 12.

However, in the case where an amount of the inorganic filler contained in the resin composition becomes too large, raised are problems such as adhesion of foreign substances derived from the inorganic filler onto the semiconductor wafer 101' and occurrence of undercut after developing the photosensitive bonding layer 12. For this reason, it is preferred that the amount of the inorganic filler contained in the resin composition is 9 wt% or less with respect to the total amount of the resin composition.

Further, in the case where the resin composition contains the acryl-based polyfunctional monomer as the photo polymerizable resin, since it is possible to sufficiently improve the strength of the spacer 104 to be formed from the photosensitive bonding layer 12 due to the addition of the acryl-based polyfunctional monomer, the addition of the inorganic filler to the resin composition can be omitted.

Examples of the inorganic filler include: a fibrous filler such as an alumina fiber and a glass fiber; a needle filler such as potassium titanate, wollastonite, aluminum borate, needle magnesium hydroxide and whisker; a platy filler such as talc, mica, sericite, a glass flake, scaly graphite and platy calcium carbonate; a globular (granular) filler such as calcium carbonate, silica, fused silica, baked clay and non-baked clay; a porous filler such as zeolite and silica gel; and the like. These inorganic fillers may be used singly or in combination of two or more of them. Among them, it is preferable to use the porous filler.

An average particle size of the inorganic filler is not limited to a specific valuer but is preferably in the range of about 0.01 to 90 μm, and more preferably in the range of about 0.1 to 40 μm. If the average particle size exceeds the upper limit value, there is a fear that appearance and resolution of the photosensitive bonding layer 12 are lowered. On the other hand, if the average particle size is less than the above lower limit value, there is a fear that the transparent substrate 102 cannot be reliably bonded to the spacer 104 even by the thermocompression bonding.

In this regard, it is to be noted that the average particle size is measured using, for example, a particle size distribution measurement apparatus of a laser diffraction type ("SALD-7000" produced by Shimadzu Corporation).

Further, in the case where the porous filler is used as the inorganic filler, an average hole size of the porous filler is preferably in the range of about 0.1 to 5 nm, and more preferably in the range of about 0.3 to 1 nm.

The resin composition constituting the photosensitive bonding layer 12 can also contain an additive agent such as a plastic resin, a leveling agent, a defoaming agent or a coupling agent in addition to the above components insofar as the purpose of the present invention is not spoiled.

By constituting the photosensitive bonding layer 12 from the resin composition as described above, it is possible

to more appropriately adjust the visible light transmission through the photosensitive bonding layer 12, to thereby more effectively prevent the exposure from becoming insufficiency during the exposing step. As a result, it is possible to provide a semiconductor device having higher reliability.

While the present invention has been described hereinabove with reference to the preferred embodiment, the present invention is not limited thereto.

For example, the semiconductor wafer bonding product is not limited to one having the above structure, but may have other members with arbitrary functions.

Further in the method of manufacturing the semiconductor wafer bonding product according to the present invention, one or more steps may be added for arbitrary purposes. For example, between the laminating step and the exposing step, a post laminate baking step (PLB step), in which the photosensitive bonding layer is subjected to a baking (heating) treatment, may be provided.

Further, in the description of the above embodiment, the exposure is carried out just once, but may be, for example, more than once.

## EXAMPLES

Hereinafter, description will be made on the present invention based on the following Examples and Comparative Example, but the present invention is not limited thereto.

[1] Manufacture of semiconductor wafer bonding product

In each of Examples and Comparative Example, 10 semiconductor wafer bonding products were manufactured as follows, respectively.

(Example 1)

1. Synthesis of alkali soluble resin (methacryloyl-modified novolac-type bisphenol A resin)

500 g of a MEK (methyl ethyl ketone) solution containing a novolac-type bisphenol A resin ("Phenolite LF-4871" produced by DIC corporation) with a solid content of 60% was added into a 2L flask. Thereafter 1.5 g of tributylamine as a catalyst and 0.15 g of hydroquinone as a polymerization inhibitor were added into the flask, and then they were heated at a temperature of 100°C. Next, 180.9 g of glycidyl methacrylate was further added into the flask in drop by drop for 30 minutes, and then they were reacted with each other by being stirred for 5 hours at 100°C, to thereby obtain a methacryloyl-modified novolac-type bisphenol A resin "MPN001" (methacryloyl modified ratio: 50%) with a solid content of 74%.

2, Preparation of resin varnish containing resin composition constituting photosensitive bonding layer

15 wt% of trimethylol propane trimethacrylate ("LIGHT-ESTER TMP" produced by KYOEISHA CHEMICAL Co., LTD.) and 5 wt% of an epoxy vinyl ester resin ("EPOXYESTER 3002M" produced by KYOEISHA CHEMICAL Co., LTD) as a photo polymerizable resin; 5 wt% of cresol novolac-type epoxy resin ("EOCN-1020-70" produced by DIC Corporation, 10 wt% of a bisphenol A-type epoxy resin ("Ep-1001" produced by Japan Epoxy Resins Co., Ltd), 5 wt% of a silicone epoxy resin ("BY 16-115" produced by Dow Cornng Toray Co., Ltd) and 3 wt% of a phenol novolac resin ("PR 53647" produced by Sumitomo Bakelite Co., Ltd.) as an epoxy resin which was a thermosetting resin; 55 wt% of the above methacryloyl-modifled novolac-type bisphenol A resin (solid content) as an alkali soluble resin; and 2 wt% of a photo polymerization initiator ("IRGACURE 651" produced by Ciba Specialty Chemicals) were weighed, and stirred at a rotation speed of 3,000 rpm for 1 hour using a disperser, to prepare a resin varnish.

3. Production of photosensitive bonding film

First, prepared was a polyester film ("MRX 50" produced by Mitsubishi Plastics, Inc.) as a support base. The polyester film had a thickness of 50 μm and visible light (600 nm) transmission of 85%.

Next, the above prepared resin varnish was applied onto the support base using a konma coater "model number: MGF No. 194001 type 3-293" produced by YASUI SEIKI) to form a coating film constituted from the resin varnish. Thereafter, the coating film was dried at 80°C for 20 minutes to form a photosensitive bonding layer. In this way, the photosensitive bonding film was obtained. In the obtained photosensitive bonding film, an average thickness of the photosensitive bonding layer was 50 μm and visible light transmission therethrough was 99%.

4. Manufacture of semiconductor wafer bonding product

First, prepared was a semiconductor wafer having a substantially circular shape and a diameter of 8 inches (Si wafer, diameter of 20.3 cm and thickness of 725 μm). In this regard, it is to be noted that 2 alignment marks were formed on the semiconductor wafer so as to be symmetrical with respect to a point corresponding to a central axis of the semiconductor wafer at a position of 100 μm from the peripheral edge of the semiconductor wafer.

Next, the above produced photosensitive bonding film was cut so as to have the same size as that of the semiconductor wafer and laminated on the semiconductor wafer using a roll laminater under the conditions in which a roll temperature was 60°C, a roll speed was 0.3 m/min and a syringe pressure of 2.0 kgt/cm$^2$, to thereby obtain the semiconductor wafer with the photosensitive bonding film.

Next, prepared was a mask provided with 2 alignment marks for positioning with respect to the semiconductor wafer and a light passing portion having the same shape as a planar shape of a spacer and a planar shape of a bonded portion to be formed, Thereafter, the mask was placed so as to face the photosensitive bonding film, while aligning the alignment marks of the mask with the alignment marks of the semiconductor wafer. At this time, a distance between the mask and the support base was set to 0 mm,

Next, the semiconductor wafer with the photosensitive bonding film was irradiated with an ultraviolet ray (wavelength of 365 nm and accumulated light intensify of 700 mJ/cm$^2$) from a side of the photosensitive bonding film so that the photosensitive bonding layer was exposed in grid-like fashion, and then the support base was removed therefrom. In this regard, it is to be noted that when exposing the photosensitive bonding layer, a width of a region to be exposed in grid-like fashion was set to 0.6 mm and a shortest distance from the peripheral edge of the semiconductor wafer to a non-exposed region (minimum width of bonded portion) is 5,000 μm so as to expose 50% of the photosensitive bonding layer at a planar view thereof.

Next, the exposed photosensitive bonding layer was developed using 2.38 wt% of tetramethyl ammonium hydroxide (TMAH) aqueous solution as a developer (alkali solution) under the conditions in which a developer pressure was 0.2 MPa and a developing time was 90 seconds. In this way, formed was a spacer composed of ribs each having a width of 0.6 mm and a bonded portion onto the semiconductor wafer.

Next, prepared was a transparent substrate (quartz glass substrate, diameter of 20.3 mm and thickness of 725 μm), This transparent substrate was bonded to the semiconductor wafer, on which the spacer had been formed, by thromocompression bonding using a substrate bonder ("SB8e" produced by Suss Microtec k.k.). In this way, manufactured was a semiconductor wafer bonding product in which the transparent substrate was bonded to the semiconductor wafer through the spacer. In this regard, it is to be noted that in the thromocompression bonding, a heating temperature was 15C°C, a pressure was 0.6 Mpa and a time was 300 seconds.

(Examples 2 to 4)

Each of semiconductor wafer bonding products was manufactured in the same manner as Example 1, except that the compounding ratio of the components contained in the resin composition constituting the photosensitive bonding layer was changed as shown in Table 1.

(Examples 5 to 7)

Each of semiconductor wafer sending products was manufactured in the same manner as Example 1, except that the minimum width of the bonded portion was changed shown in Table 1.

(Comparative Example)

Each of semiconductor wafer bonding products was manufactured in the same manner as Example 1, except that the bonded portion was not formed along the peripheral edge of the semiconductor wafer by carrying out the exposure using a mask provided with a light passing portion having only the same shape as a planar shape of a spacer to be formed.

In each of Examples and Comparative Example, the kind and amount of each component contained in the resin composition constituting the photosensitive bonding layer, the thickness of the spacer of the semiconductor wafer bonding product are shown in Table 1.
In Table 1, indicated are the methacryloyl-modified novolac-type bisphenol A resin as "MPN", the trimethylol propane trimethacrylate as "TMP", the epoxy vinyl ester resin as "3002", the cresol novolac-type epoxy resin as "EOCN", the bisphenol A-type epoxy resin as "EP", the silicone epoxy resin as "BY16" and the phenol novolac resin as "PR", respectively.

[Table 1]

Table 1

| | Photosensitive bonding film | | | | | | | | | | | | | | | Semiconductor wafer bonded body |
|---|---|---|---|---|---|---|---|---|---|---|---|---|---|---|---|---|
| | Components of resin composition constituting photosensitive bonding layer | | | | | | | | | | | | | | | Minimum width of bonded portion [mm] |
| | Alkali soluble resin | | Photo polymerizable resin | | | | Thermosetting resin | | | | | | | | Photo polymerzation initiator | |
| | Kind | Amount [wt%] | Kind | Amount [wt%] | Kind | Amount | Kind | Amount [wt%] | Kind | Amount [wt%] | Kind | Amount [wt%] | Kind | Amount [wt%] | Amount [wt%] | |
| Ex. 1 | MPN | 55 | TMP | 15 | 3002 | 5 | ECON | 5 | EP | 10 | BY16 | 5 | PR | 3 | 2 | 5 |
| Ex. 2 | MPN | 40 | TMP | 20 | 3002 | 5 | ECON | 5 | EP | 20 | BY16 | 5 | PR | 3 | 2 | 5 |
| Ex. 3 | MPN | 35 | TMP | 20 | 3002 | 5 | ECON | 5 | EP | 25 | BY16 | 5 | PR | 3 | 2 | 5 |
| Ex. 4 | MPN | 65 | TMP | 15 | 3002 | 5 | EP | 5 | BY16 | 5 | PR | 3 | - | - | 2 | 5 |
| Ex. 5 | MPN | 55 | TMP | 15 | 3002 | 5 | ECON | 5 | EP | 10 | BY16 | 5 | PR | 3 | 2 | 2 |
| Ex. 6 | MPN | 55 | TMP | 15 | 3002 | 5 | ECON | 5 | EP | 10 | BY16 | 5 | PR | 3 | 2 | 0 5 |
| Ex. 7 | MPN | 55 | TMP | 15 | 3002 | 5 | ECON | 5 | EP | 10 | BY16 | 5 | PR | 3 | 2 | 0.1 |
| Com Ex. | MPN | 55 | TMP | 15 | 3002 | 5 | N865 | 5 | EP | 10 | BY16 | 5 | PR | 3 | 2 | - |

[2] Ratio of die shear strength of bonded portion after being dipped into etching solution with respect to that of bonded portion before being dipped into etching solution
The photosensitive bonding layer on the photosensitive bonding film obtained in each of Examples and Comparative Example was attached to a borosilicate glass substrate using a laminating machine under the conditions in which a temperature was 60°C and a laminating speed was 0.3 minutes. Next, for example, a photosensitive bonding layer having a size of 2 mm square is formed under the conditions including exposure (700 J/cm$^2$) and development (3% TMAH developer, 25°C/0.3 MPa/90 sec).
Next, a borosilicate glass base having a size of 2 mm square is placed on the photosensitive bonding layer, the glass substrates are bonded together by thermocompression bonding (120°C × 0.8 MPa × 5 s). A sample for measuring die Shear strength is obtained by subjecting the bonded glass substrates to a heat history of 150°C × 90 minutes. In the same manner as described above, 20 samples are obtained in total.
10 obtained samples are untreated, and other 10 obtained samples are treated using an etching solution ("FE-830" produced by EBARA DENSAN LTD.) of 30°C for 5 minutes and washed using pure water for 5 minutes. On each of the samples, the die shear strength thereof is calculated using a die shear strength measuring machine.
Further, a ratio of the die shear strength of the sample after being dipped into the etching solution with respect to that of the sample before being dipped into the etching solution is calculated based on the following expression.

Ratio of die shear strength (%) = (Die shear strength of sample after being dipped into etching solution) / (Die shear strength of untreated sample) × 100

[3] Evaluation of liquid-tight property

The semiconductor wafer bonding product manufactured in each of Examples and Comparative Example was dipped into an etching solution ("FE-830" produced by EBARA DENSAN LTD.) for 5 minutes and washed using pure water for 5 minutes. Thereafter, the semiconductor wafer bonding product is removed from the etching solution, and then air-gap portions of the removed semiconductor wafer bonding product were observed and presence or absence of the etching solution penetrating into the air-gap portions was evaluated based on the following evaluation criteria.

A: The number of the air-gap portions into which the etching solution has penetrated is "0".
B: The number of the air-gap portions into which the etching solution has penetrated is 1 to 2.
C: The number of the air-gap portions into which the etching solution has penetrated is 3 or more.

[4] Manufacture of semiconductor device (light receiving device)

The semiconductor wafer bonding product manufactured in each of Examples and Comparative Example was diced along a portion corresponding to the spacer using a dicing saw, to thereby obtain a plurality of light receiving devices.

[5] Reliability of light receiving device

10 obtained light receiving devices, were subjected to 1,000 cycles of a heat cycle test in which a treatment at -55°C for 1 hour and a treatment at 125°C for 1 hour were repeatedly performed and then observation of cracks or peel-off was carried out and evaluated based on the following evaluation criteria.

A: No cracks and peel-off were observed in all the light receiving devices, and thus they are not practically a problem at all.
B: A few cracks and peel-off were observed in two or less light receiving devices, but they are not practically a problem.
C: Cracks and peel-off were observed in three or more light receiving devices, and thus they do not have a practical level.
D: Cracks and peel-off were observed in eight or more light receiving devices, and thus they do not have a practical level.

This result is also shown in Table 2 together with the above result.
[Table 2]

Table 2

| | Ratio of die shear strengths | Liquid-tight property | Reliability of light receiving device |
|---|---|---|---|
| Ex. 1 | 76 | A | A |
| Ex. 2 | 88 | A | A |
| Ex. 3 | 96 | A | A |
| Ex. 4 | 63 | B | B |
| Ex. 5 | 76 | A | A |
| Ex. 6 | 76 | A | A |
| Ex. 7 | 76 | A | B |
| Com. Ex. | 76 | C | D |

As shown in Table 2, in each of the semiconductor wafer bonding products according to the present invention, the etching solution does not penetrate into the air-gap portions, and thus an excellent liquid-tight property is obtained. Therefore, the present invention exhibits superior productivity. Further, in each of the semiconductor wafer bonding products, the spacer does not have cracks and has excellent dimensional accuracy. Furthermore, each of the semiconductor devices manufactured using the semiconductor wafer bonding products according to the present invention has especially higher reliability.

On the other hand, the semiconductor wafer bonding product of Comparative Example does not have a sufficient liquid-tight property, and thus cannot exhibit superior productivity.

## INDUSTRIAL APPLICABILITY

According to the present invention, it is possible to provide a semiconductor wafer bonding product that can prevent a cleaning fluid, an etching solution or the like from penetrating into an inside thereof in processing a rear surface of a semiconductor wafer, and thus has excellent productivity of semiconductor devices. Further, it is also possible to provide a manufacturing method capable of easily manufacturing such a semiconductor wafer bonding product. Furthermore, it is also possible to provide a semiconductor device having superior reliability, Accordingly, the present invention has industrial applicability,

## Claims

1. A semiconductor wafer bonding product, comprising:

    a semiconductor wafer;
    a transparent substrate provided at a side of a functional surface of the semiconductor wafer;
    a spacer provided between the semiconductor wafer and the transparent substrate; and
    a bonded portion continuously provided along a periphery of the semiconductor wafer, the transparent substrate being bonded to the semiconductor wafer througn the bonded portion.

2. The semiconductor wafer bonding product as claimed in claim 1, wherein a minimum width of the bonded portion is 50 $\mu$m or more.

3. The semiconductor wafer bonding product as claimed in claim 1, wherein a ratio of die shear strength of the bonded portion after being dipped into an etching solution with respect to that of the bonded portion before being dipped into the etching solution is 40% or more.

4. The semiconductor wafer bonding product as claimed in claim 1, wherein the bonded portion is integrally formed with the spacer.

5. A method of manufacturing the semiconductor wafer bonding product defined by claim 1, comprising:

a step of forming a photosensitive bonding layer having a shape corresponding to that of the semiconductor wafer and having a bonding property onto the functional surface of the semiconductor wafer;
a step of selectively exposing a region of the photosensitive bonding layer to be formed into the spacer and the bonded portion via a mask;
a step of developing the photosensitive bonding layer to form the spacer and the bonded portion on the semiconductor wafer; and
a step of bonding the transparent substrate to surfaces of the spacer and the bonded portion opposite to the semiconductor wafer.

**6.** A method of manufacturing the semiconductor wafer bonding product defined by claim 1, comprising:

a step of forming a photosensitive bonding layer having a shape corresponding to that of the semiconductor wafer and having a bonding property onto the transparent substrate;
a step of selectively exposing a region of the photosensitive bonding layer to be formed into the spacer and the bonded portion via a mask;
a Step of developing the photosensitive bonding layer to form the spacer and the bonded portion on the transparent substrates and
a step of bonding the semiconductor wafer to surfaces of the spacer and the bonded portion opposite to the transparent substrate.

**7.** The method as claimed in claim 5 or 6, wherein the photosensitive bonding layer is formed of a material containing an alkali soluble resin, a thermosetting resin and a photo polymerization initiator.

**8.** The method as claimed in claim 7, wherein the alkali soluble resin is a (meth)acryl-modified phenol resin.

**9.** The method as claimed in claim 7, wherein the thermosetting resin is an epoxy resin.

**10.** The method as claimed in claim 7, wherein the material further contains a photo polymerizable resin.

**11.** A semiconductor device obtained by dicing the semiconductor wafer bonding product defined by claim 1 along a portion corresponding to the spacer to obtain a plurality of chips of semiconductor devices.

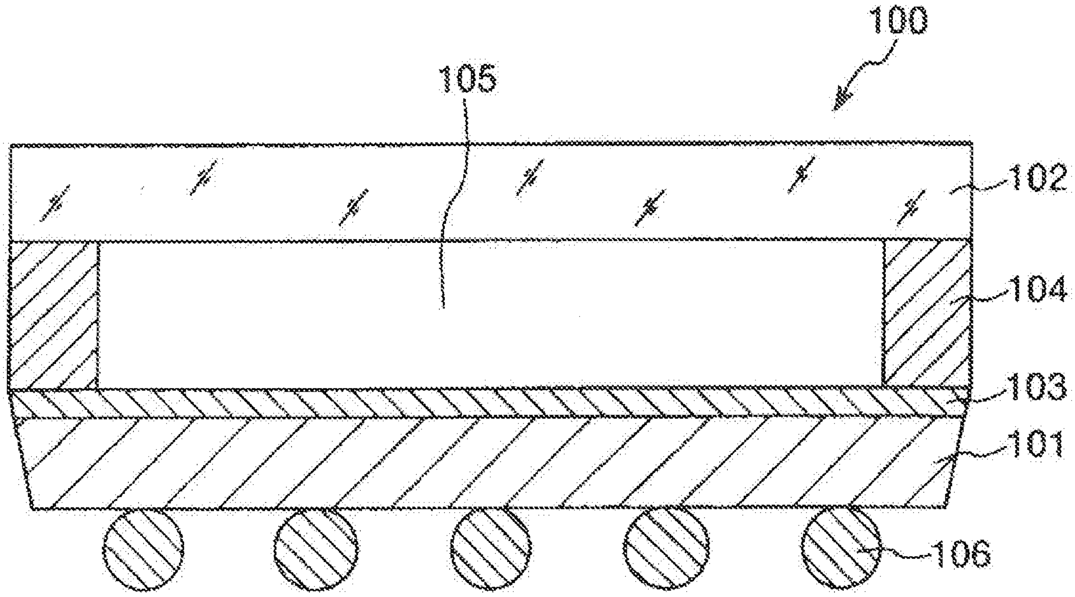


FIG. 1

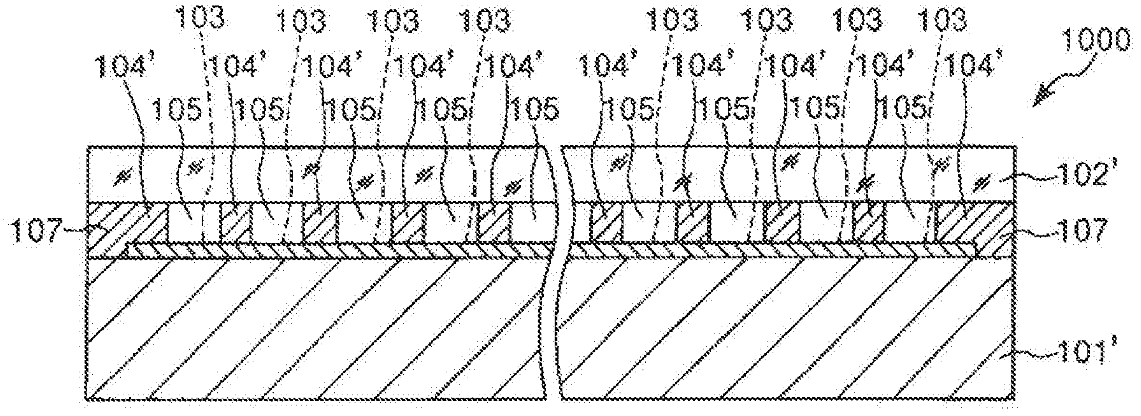


FIG. 2

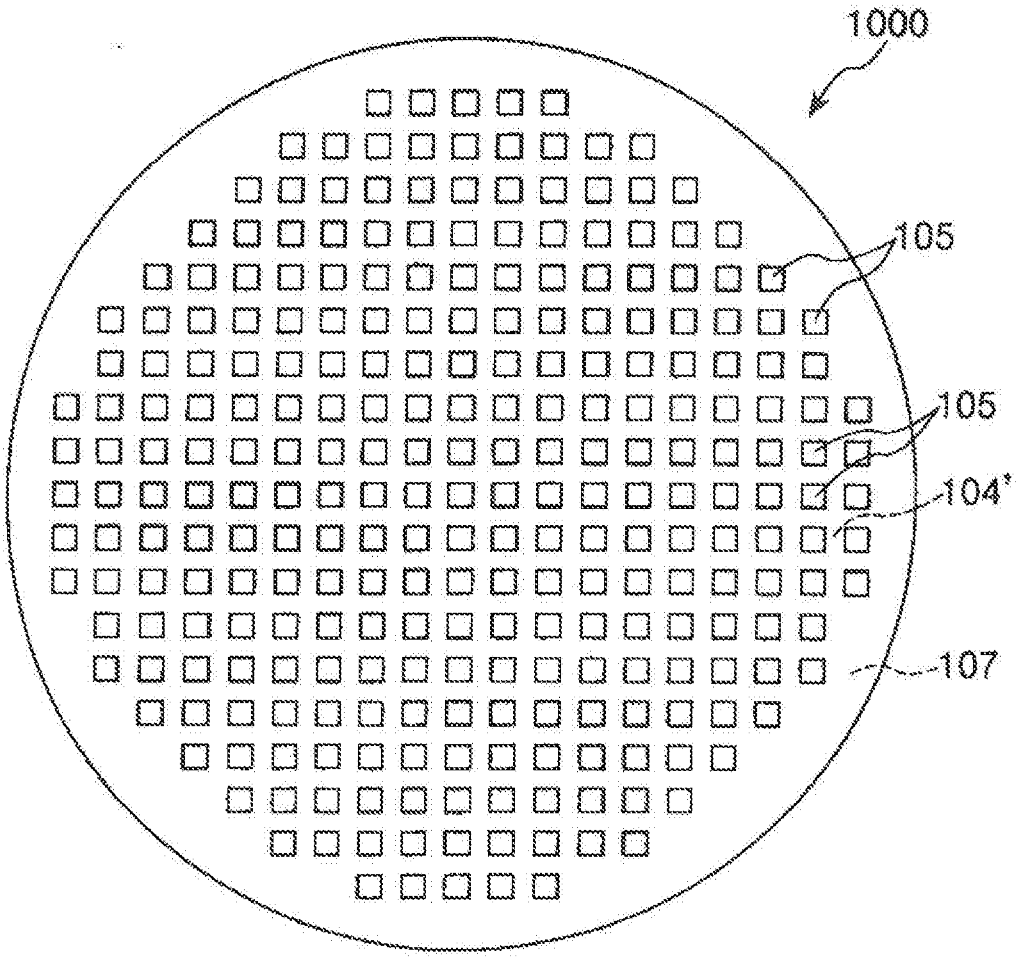


FIG. 3

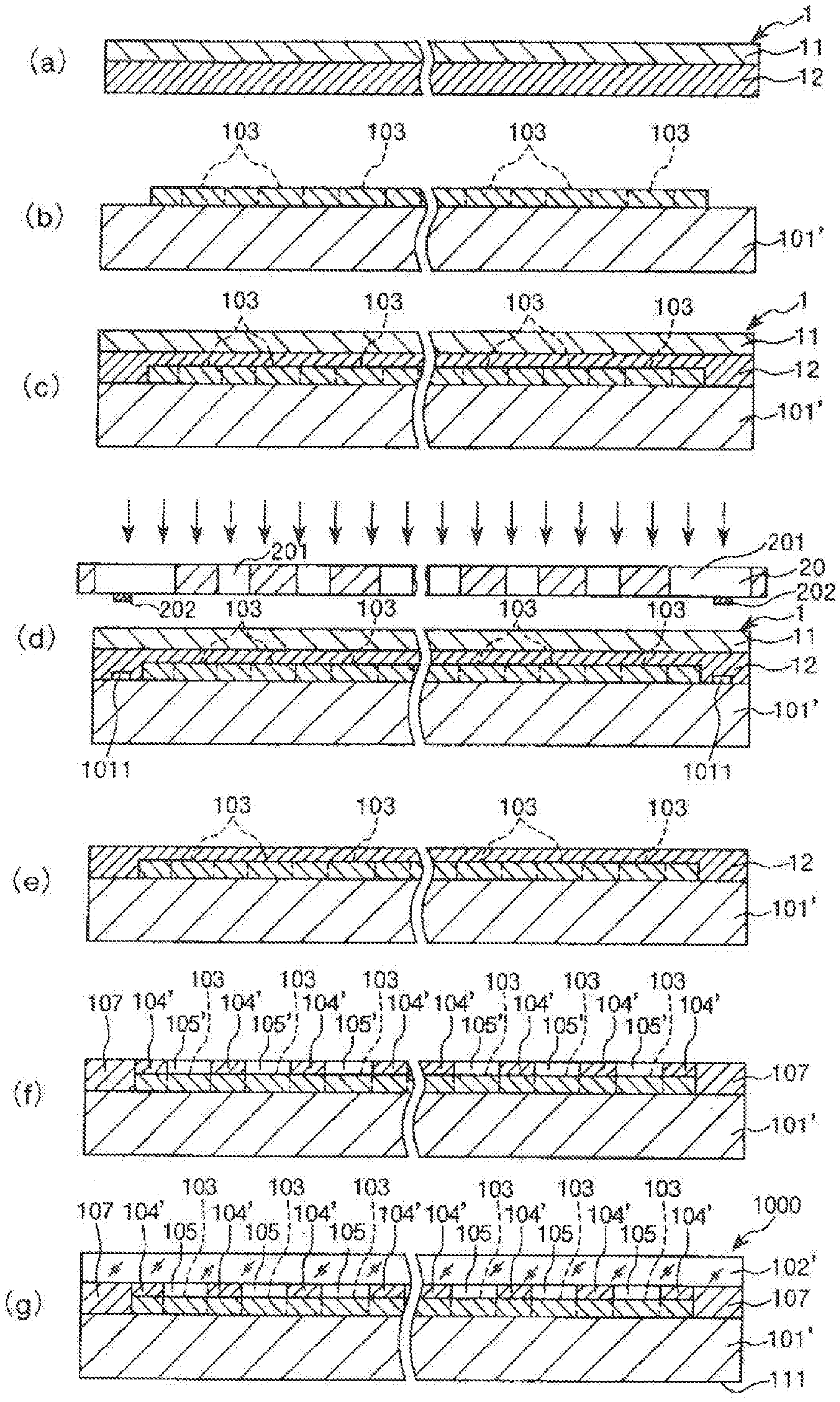
(a)
(b)
(c)
(d)
(e)
(f)
(g)
1
11
12
103
101'
201
20
202
1011
104'
105'
105
107
1000
102'
111

FIG. 4

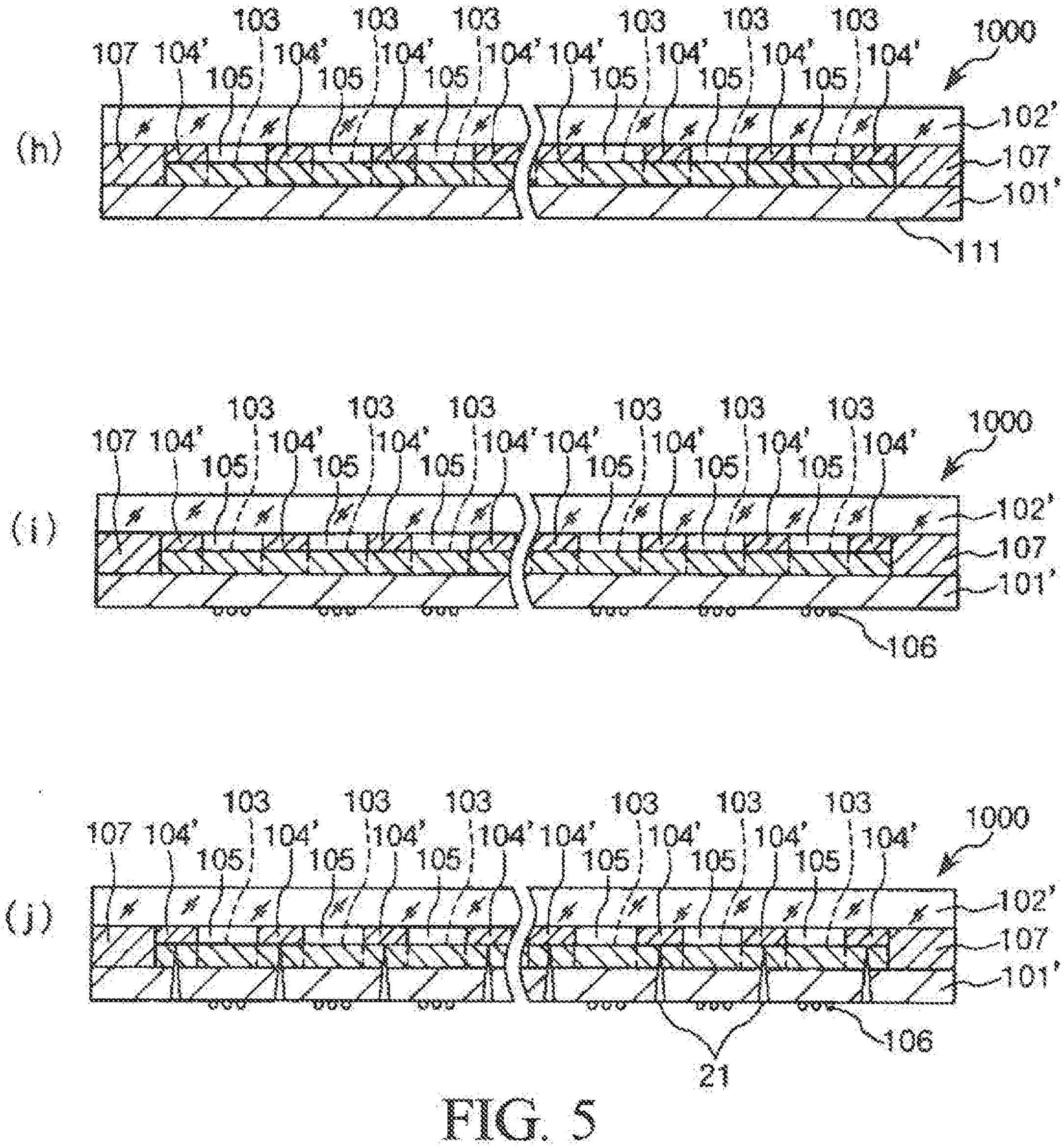


FIG. 5

## INTERNATIONAL SEARCH REPORT

International application No.
PCT/JP2010/052194

A. CLASSIFICATION OF SUBJECT MATTER
*H01L23/02*(2006.01)i, *H01L23/10*(2006.01)i, *H01L27/14*(2006.01)i

According to International Patent Classification (IPC) or to both national classification and IPC

B. FIELDS SEARCHED

Minimum documentation searched (classification system followed by classification symbols)
H01L23/02, H01L23/10, H01L27/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-100763 A (Fuji Photo Film Co.,Ltd.),<br>13 April 2006 (13.04.2006),<br>entire text; all drawings<br>& US 2006/0051887 A1 | 1-4,11<br>5-10 |
| X<br>Y | JP 2007-115878 A (Fujifilm Corp.),<br>10 May 2007 (10.05.2007),<br>entire text; all drawings<br>(Family: none) | 1-3,11<br>5-10 |
| Y | JP 2005-354081 A (Samsung Electronics Co., Ltd.),<br>22 December 2005 (22.12.2005),<br>entire text; all drawings<br>& US 2006/0006486 A1 & KR 10-2006-0045888 A<br>& CN 1722456 A | 5-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>25 February, 2010 (25.02.10) | Date of mailing of the international search report<br>09 March, 2010 (09.03.10) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2010/052194

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2008/155896 A1 (Sumitomo Bakelite Co., Ltd.), 24 December 2008 (24.12.2008), entire text; all drawings (Family: none) | 5-10 |
| Y | WO 2008/146723 A1 (Sumitomo Bakelite Co., Ltd.), 04 December 2008 (04.12.2008), entire text; all drawings & JP 2009-15309 A | 5-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004312666 A